Europäisches Patentamt

European Patent Office

Office européen des brevets

(19)

(11) Veröffentlichungsnummer: **0 258 231**

**B1**

(12) **EUROPÄISCHE PATENTSCHRIFT**

(45) Veröffentlichungstag der Patentschrift: **08.08.90**

(51) Int. Cl.⁵: **G 01 R 13/34**

(21) Anmeldenummer: **86902314.3**

(22) Anmeldetag: **27.03.86**

(86) Internationale Anmeldenummer:
**PCT/DE86/00144**

(87) Internationale Veröffentlichungsnummer:
**WO 86/05885 09.10.86 Gazette 86/22**

(54) **SIGNALVERARBEITUNGSGERÄT.**

(30) Priorität: **27.03.85 DE 3511592**

(43) Veröffentlichungstag der Anmeldung:
**09.03.88 Patentblatt 88/10**

(45) Bekanntmachung des Hinweises auf die
Patenterteilung:
**08.08.90 Patentblatt 90/32**

(84) Benannte Vertragsstaaten:
**AT BE CH DE FR GB IT LI NL SE**

(56) Entgegenhaltungen:
**US-A-42 246 72**
**US-A-44 556 13**
**Radio Fernsehen Elektronik, Band 28, Nr. 9, 1979, Berlin (DD) W. Bobe: "Digitalspeicher in der Oszillographen-Messtechnik", Seiten 562-565, siehe Seite 563, Absatz: "Digitale Halbleiterspeicher"; Figuren 1-4, 6**
**Tekscope, Band 12, Nr. 3, 1980, Voorschoten (NL) B. Blair: "100 Mhz portable oscilloscope packs digital storage power", Seiten 10-13, siehe Seite 12, Absatz "Adding digital storage"; Figur 4**

(73) Patentinhaber: **CREATEC GESELLSCHAFT FÜR ELEKTROTECHNIK MBH**
**Limburger Str. 42**
**D-1000 Berlin 65 (DE)**

(72) Erfinder: **KOSLAR, Manfred**
**Benediktiner Str. 22**
**D-1000 Berlin 28 (DE)**

(74) Vertreter: **Christiansen, Henning, Dipl.-Ing. et al**
**Patentanwalt CHRISTIANSEN Pacelliallee 43/45**
**D-1000 Berlin 33 (DE)**

(56) References cited:
**Electronic Disign, Band 28, Nr. 3, 1980, Rochelle Park (US) N.A. Robin: "Capture fast waveforms accurately with a 2-channel programmable digitizer", Seiten 50-55**

**Beschreibung**

Die Erfindung betrifft ein Signalverarbeitungsgerät der im Oberbegriff des Anspruchs 1 angegebenen Art, wie es vorzugsweise u. a. als digitaler Speicheroszillograph Verwendung findet.

Ein ein digitaler Speicher-Oszillograph dient der Darstellung von Wellenformen. Hierbei wird ein analoges Eingangssignal' digitalisiert. Die digitalen Daten werden für die nachfolgende Anzeige der analogen Wellenform oder für eine Berechnung mittels einen digitalen Prozessors (µP) gespeichert.

Derartige digitale Speicher-Oszillographen gewinnen zunehmend an Bedeutung, weil sie einzigartige Merkmale, wie beispielsweise die Pre- und Post-Triggerung eine beliebig lange Speicherzeit und verschiedene Signalverarbeitungen ermöglichen, die mit herkömmlichen, in Echtzeit arbeitenden Oszillographen nicht erreichbar sind. Dabei ermöglichen diese Merkmale in Verbindung mit der fortgeschrittenen digitalen Technologie eine vergrößerte Abtastgeschwindigkeit und eine heraufgesetzte Speicherkapazität.

Es sind weiterhin in diesem Zusammenhang Lösungen bekannt, welche unter Verwendung integrierter Schaltkreise und der LSI-Technologie analoge Speicher für hohe Geschwindigkeiten, wie beispielsweise CCD-Schaltungen als analoge Schieberegister aufweisen. Dabei ist aus der DE—A—33 38 381 ein verbesserter Speicher-Oszillograph bekannt, der ein derartiges analoges Schieberegister enthält. Der Nachteil bei der Verwendung von CCD-Schaltungen besteht aber darin, daß diese Speicher nicht unabhängig von der gewählten Zeitbasis funktionsfähig sind. Die vorgenannte Schrift beschreibt daher einen Oszillographen, der in Abhängigkeit von der Einstellung der Zeitbasis in einer Mehrzahl von unterschiedlichen Betriebsarten arbeitet. Eine derartige Lösung ist jedoch unnötig aufwendig und hebt die mit einer digitalen Signalverarbeitung generell erzielbaren Vorteile zum größten Teil wieder auf.

Die dabei bestehenden Schwierigkeiten lassen sich wie folgt charakterisieren:

Digitale Oszillographen erfassen elektrische Signale durch Quantisierung von Abtastwerten, die in getrennten Zeitintervallen aufgenommen werden und danach in quantisierter Form in einen Speicher für die spätere Darstellung als rückgewonnene Wellenform eingegeben werden. Zunächst war die scheinbare Bandbreite digitaler Oszillographen begrenzt, weil alle Abtastwerte, die zu einer Wellenform gehören, nacheinander je in einer einzigen Periode des Signals mit der Abtasttaktfrequenz aufgenommen werden mußten. Ursache hierfür war die asynchrone Beziehung zwischen dem Triggervorgang und dem Abtasttakt. Diese Betriebsweise ist auf dem Gebiet digitaler Oszillographen als einmalige Erfassung pro Taktung bekannt.

Die scheinbare Bandbreite der Signalerfassung wurde bei einer Betriebsweise mit einer Signalserfassung, die der zeitäquivalenten Zufallsstichprobenerfassung ähnlich ist, beträchtlich ausgeweitet. Diese beinhaltet die Erfassung von Stellen in den jeweiligen Perioden eines sich wiederholenden Signals und die Wiederherstellung einer einzigen zeitäquivalenten Periode des Signals aus diesen Stellen, obwohl die Wellenformabtastwerte durch viele Perioden voneinander getrennt aufgenommen worden sein können. Eine Schwierigkeit, die mit einer solchen zeitäquivalenten Wellenformrückgewinnung zusammenhängt, besteht darin, daß eine verhältnismäßig lange Zeit für die Erfassung aller relevanten Abtastwerte notwendig ist, die die jeweiligen Datenpunkte darstellen.

Eine andere Schwierigkeit besteht darin, daß der Triggerpunkt, der in allen aufeinanderfolgenden Perioden des Signals gleich ist, und der Abtasttakt, der eine vorbestimmte feste Frequenz hat, nicht aufeinander abgestimmt sind. Hieraus ergibt sich, daß die dargestellten Datenpunkte zueinander ein horizontales Flattern zeigen. Dieses Problem ist in der US—A—4 251 754 angesprochen die auf Luis J. NAVARRO und Thomas P. DAGOSTINO zurückgeht. In dieser Schrift wird ausgeführt, daß das Flattern aufgrund der Abtastunbestimmtheit durch Messung des Zeitintervalls zwischen einem Triggererkennungsvorgang (der auftritt, wenn das Signalpotential einen wählbaren Schwellenwert durchläuft) und dem nächstfolgenden Abtasttaktimpuls und durch die Verwendung des Meßwerts zur Erzeugung eines Offset-Stroms im horizontalen Darstellungssystem zu korrigieren ist, wodurch jeder Rahmen der Darstellung horizontal verschoben wird. Hierbei wird jeder dargestellte Abtastwert in seine genaue Zeitlage gebracht. Diese Lösung des Flatterproblems eignet sich jedoch nicht für die dazwischenliegende Wellenformverarbeitung mit einem Computer oder dergleichen, da die Korrektur nur im Darstellungssystem stattfindet.

Ein anderer Gesichtspukt bei der zeitäquivalenten Wellenformrückgewinnung ist der Einfluß der unteren Nyquist-Grenze auf die Abtastfrequenz der periodischen Abtastung. Wenn die Abtastfrequenz kleiner als die doppelte Frequenz des Eingangssignals it, dann geht Information wegen zu weniger Abtastungen verloren. Unter Umständen ergibt sich hieraus eine verzerrt dargestellte Wellenform. Es war deshalb wünschenswert, sowohl zahlreiche Abtastwerte für jede Triggererkennung zu erhalten als auch die genaue zeitäquivalente Lage jedes abgetasteten Datenpunkts im Erfassungsprozeß vorzusehen.

Aus der DE—A—33 27 133 ist in diesem Zusammenhang ein Verfahren zur Erfassung einer zeitäquivalenten Wellenform während einer Vielzahl von Perioden eines sich wiederholenden Eingangssignals bekannt, bei dem aus jeder Periode der Vielzahl von Perioden ein oder mehrere Abtastwerte in getrennten Intervallen eines Abtasttaktes erfaßt werden, wobei die Zeitdifferenz zwischen einem festen Punkt in jeder Periode und dem nächstfolgenden Taktimpuls gemessen wird, bei dem aus der gemessenen Zeitdifferenz eine Speicheradresse für jeden Abtastwert bestimmt wird und bei dem die Abtastwerte im Speicher unter der berechneten Adresse gespeichert werden.

Auch dieses Verfahren ist sehr aufwendig und führt dazu, daß ein Signalverlauf erst einige Zeit nach seinem Erscheinen am Eigang des Oszillographen auf dem Schirm dargestellt werden kann, da die beschriebene Signalverarbeitung eine gewisse Zeit in Anspruch nimmt. Das ist insbesondere deshalb störend, weil es sich ohnehin um relativ langsam ablaufende Vorgänge handelt.

Ein derartiges Signalverarbeitungsgerät ist aus der US—A—4 455 613 bekannt.

Weiterhin ist aus der Schrift "Radio Fernsehen Elektronik", Band 28, Nr. 9, 1979, Berlin (DD), W. Bobe: "Digitalspeicher in der Oszillographentechnik", Seiten 562 bis 565, allgemein der Einsatz von Digitalspeichern in Signalverarbeitungsgeräten unter Nennung verschiedener Speichertypen wie Schieberegister und RAMs beschrieben.

Außerdem ist aus der Zeitschrift "Tekscope", Band 12, Nr. 3, 1980, Voorschoten (NL), B. Blair: "100 MHz portable oscilloscope packs digital storage power", Seiten 10 bis 13, ein vollprogrammierbares digitales Signalverarbeitungsgerät bekannt. Hierin wird unter anderem auf die separate Zeitgebung für Datenauswahlimpulse und weitere Taktsignale hingewiesen. Insbesondere ist hier auch ein eigener digitaler Zeitgeberbaustein vorgesehen.

Der im kennzeichnenden Teil des Anspruchs 1 angegebenen Erfindung liegt die Aufgabe zugrunde, ein Signalverarbeitungsgerät und insbesondere einen digitalen Speicheroszillographen der eingangs genannten Gattung so auszubilden, daß er eine inheitliche Signalverarbeitung unabhängig von der gewählten Zeitbasis sowohl für sehr schnell als auch für langsam ablaufende Vorgänge ermöglicht.

Die Erfindung beruht auf der Erkenntnis, daß bei einem digitalen Signalverarbeitungsgerät die Digitalisierung möglichst unmitttelbar nach dem analogen Signaleingang erfolgen sollte, damit sämtliche Handhabungen und Steuerungen innerhalb des digitalen Teils des Gerätes ohne weitere Digital-Analog-Wandlungen auskommen können.

Durch die Verwendung eines Schieberegisters als Zwischenspeicher mit einem vom die digitale Signalverarbeitung am Ausgang des Schieberegisters ausführenden Mikroprozessor getrennten Kontroller bietet sich der Vorteil, daß für die Hochgeschwindigkeits-Signalverarbeitung lediglich eine einfache Taktsteuerung erforderlich ist.

Bei niedrigeren Anforderungen bezüglich der Signalverarbeitungsgeschwindigkeit im Eingang, d.h. bei der Bearbeitung von Signalen mit ausschließlich niedrigeren Frequenzanteilen wird das Schieberegister mit einer entsprechend niedrigeren Taktfrequenz betrieben, wobei zwischen den Taktimpulsen genügend Zeit verbleibt, um die einzelnen Signale der Weiterverarbeitung durch die nachfolgende Prozessorschaltung zuzuführen. Bei sehr hochfrequenten Eingangssignalen erfolgt die Signalaufnahme für einen Signalzug geschlossen, wobei das Auslesen zur nachfolgenden Weiterverarbeitung durch den nachgeschalteten Mikroprozessor geringerer Geschwindigkeit zwischen den Signalaufnahmezyklen mit verlangsamter Geschwindigkeit erfolgen kann. Dadurch, daß eine einen eigenen Signalspeicher enthaltende Anzeigevorrichtung verwendet wird, kan ein Bildwechsel in Zeitabständen erfolgen, der völlig ausreichend ist, um zwischenzeitlich die für den nachfolgend anzuzeigenden Bildinhalt notwendigen Verarbeitungen intervallweise durchzuführen.

Dadurch, daß die in das Schieberegister inzulesenden digitalen Signalwerte mittels eines Komparators überwacht und bei Eintreffen einer vorgegebenen Übereinstimmung eine vorprogrammierte Signalverarbeitung unter Berücksichtigung eines die Taktanzahl der bisher in das Schieberegister eingelesenen Signale repräsentierenden Zählerstands erfolgt, ist bei der im an das Schieberegister anschließende Signalverarbeitungsteil erfolgenden Bearbeitung eine sehr große Freiheit gegeben. In Abhängikeit von vorgegebenen, durch den "digitalen Trigger" zu erkennenden Ereignisse wird bevorzugt die Darstellung des aufgenommenen Signalzuges auf dem schirm beeinflußt, wobei durch extern zu beinflussende Wählmittel vorgebbar ist, in welcher geometrischen Position ein vorbestimmtes Ereignis auf dem Wiedergabeschirm erscheinen soll. Um hier die volle Freiheit bezüglich der Verwendung eines "PRE-" und POST-"Triggers zu haben, weist in günstiger Weise der Bildschirmspeicher die doppelte Speicherkapazität des Schieberegisters auf.

Durch Vorprogrammierung bestimmter Verarbeitungsfunktionen läßt sich für vorgegebene Bereiche der Signaldarstellung eine "Dehnung" der Signaldarstellung durch eine zeitweise Erhöhung der Taktfrequenz des Schieberegisters erreichen. Des weiteren werden durch den "digitalen Trigger" in vorteilhafter Weise Umschaltungsvorgänge zwischen den zwei Signalverarbeitungskanälen in der Weise vorgenommen, daß Teile der erscheinenden Signale bei einkanaliger Verarbeitung im Anzeigefeld für einen sonst nutzbaren zweiten Kanal erscheinen.

Bei einer anderen bevorzugten Weiterbildung der Erfindung läßt sich die Abtastfrequenz des Eingangssignals bei der Digitalisierung dadurch vergrößern, daß abwechselnd jeder der Flash-Wandler der beiden Verarbeitungskanäle Signale für ein und denselben Signalzug bereitstellt.

Vorteilhafte Weiterbildungen der Erfindung sind in den Unteransprüchen gekennzeichnet bzw. werden nachstehend zusammen mit der beschreibung der bervorzugten Ausführung der Erfindung anhand der Figuren näher dargestellt. Es zeigen:

Figur 1 ein bevorzugtes Ausführungsbeispiel als Blockschaltbild,

Figur 2 ein Blockschaltbild des Kreuzmultiplexers als Detail des Ausführungsbeispiels gemäß Figur 1 sowie.

Figur 3 ein Blockschaltbild des Conversionsprozessors als weiteres Detail des Ausführungsbeispiels gemäß Figur 1.

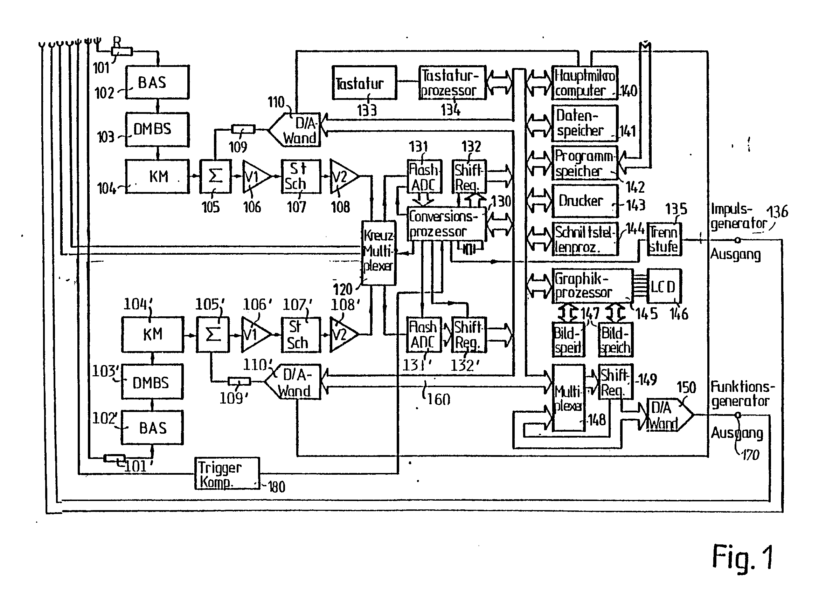

Die anhand von Fig. 1 zu beschreibenden Baugruppen 101 bis 108 folgen bezüglich der Signalverarbeitung entsprechend der Fogle der Bezugszeichen aufeinander, d.h. das Eingangssignal der vorangehenden Stufe wird jeweils der nachfolgenden Stufe zugeführt. Die beiden Eingangskanäle sind insoweit symmetrisch ausgebildet, so daß die entsprechenden Baugruppen des anderen Kanals nicht gesondert beschrieben zu werden brauchen. Ihre Bezugszeichen sind entsprechend mit einem (') versehen.

**Der Betriebsartenschalter (BAS) 102**

Das analoge Eingangssignal wird über einen hochohmigen Sicherheitsvorwiderstand 101 dem Betriebsartenschalter 102 zugeführt. Der Betriebsartenschalter 102 gestattet es, die Gleichspannungskopplung (DC), die Wechselspannungskopplung (AC) und die Stellung "Eingang kurzgeschlosen" (GROUND) über einen mechanischen Schiebeschalter anzuwählen.

Gleichzeitig kann über diesen Schalter das Gerät über die Schalterstellung "Aus" (Off) ein- oder ausgeschaltet werden. Der Betriebsartenschalter 102 beinhaltet einen mechanisch parallel geschalteten Kodierschalter, der dem später zu beschreibenden Mikrocomputer die jeweilige Schalterstellung meldet.

**Der dekadische Meßbereichsschalter (DMBS) 103**

Außer dem Betriebsartenschalter 102 befindet sich pro Kanal noch ein Meßbereichsschalter in dem Gerät, der die Anpassung der Signalamplitude an die Pegelverhältnisse der weiteren Stufen erlaubt. Der Meßbereichsschalter (MBS) besteht aus vier Hauptteilen. Er wird einem elfstufigen Mehrebenenschiebeschalter gebildet, dessen erster Teil der dekadische Meßbereichsschalter (DMBS) 103 ist. Er dient dazu, die Verstärkung und Abschwächung der Eingangssignale über durch den Schalter veränderbare Widerstandsnetzwerke an einem Summationspunkt vorzunehmen.

**Der Kalibrationsmultiplexer (KM) 104**

Mit Hilfe des Kalibrationsmultiplexers 104 kann der Analogsignaleingang EI vom Summationspunkt 105 getrennt werden und über den DA-Wandler 110 vom Hauptmikrocomputer 140 gesteuert auf den Summationspunkt 105 über den Widerstand R109 schrittweise ein Gleichspannungssignal zugeführt werden, das am Summationspunkt S zugeführt, am Eingang der Verstärkerkette eingespeist, die gesamte Verstärkerkette passiert und über das Flash-AD-Wandler-System 131 dem Hauptmikrocomputer 140 zur auswertung als digitales Signal zurückgegeben wird. Da dieser die SOLL-Signale selbst generiert hat, kann er die eintreffenden IST-Signale in einer Eichtabelle ablegen und so bei dem folgenden Meßvorgang, bei dem der Kalibrationsmultiplexer 104 wieder die Signalquelle aufschaltet, eine unter Umständen notwendige Korrektur bei der Bewertung der eintreffenden IST-Signale nach der abgelegten Korrekturtabelle vornehmen.

**Der Summationspunkt 105**

Einen entscheidenden Einfluß auf die Vielseitigkeit und nahezu ideale systemanalytische Vorteile bietet der Summationspunkt S. Er wird durch den Summationspunkt eines potentiometrisch beschalteten Gleichspannungs-Breitbandverstärkers gebildet. An ihm können die aus dem DA-Wandler stammenden Gleichspannungsignale zur automatischen Nullpunktkorrektur und zur Autokalibrations eingeschaltet werden. Gleichzeitig dient er als virtuelle Masse für die durch den dekadischen Meßbereichsschalter geschaltete Eichleitung.

**Der hochohmig beschaltete Meßvorverstärker (VI) 106**

Der Meßvorverstärker 106 wird durch einen aus diskreten Halbleiterbauelementen aufgebauten Gegentaktbrückenverstärker gebildet und setzt zusammen mit dem als Stromteiler aufgebauten Eichteiler in potentiometrischer Beschaltung die Eingangssignale herauf.

Er trennt auf diese Weise die Eichleitung, die eine dekadische Stufung der gesamten Verstärkung von 5-fach, 0,5-fach, 0,05-fach erlaubt von dem dem Verstärker VI nachgeschalteten Stufenschalter 107.

**Der Stufenschalter (StSch) 107**

Um die große Anzahl von Meßbereichen ohne allzu großen Aufwand im hochohmigen Teil der als Eichleitung gebildeten Eingangsschaltung bewältigen zu können, werden in den einzelnen 11 Meßbereichsstufen die dekadischen Anteile durch den dekadischen Meßbereichsschalter 103 vorgenommen. In den dazwischenliegenden Pegelanpassungsstufen 1; 0,5; 0,2 wird diese zusätzliche Teilung nach dem ersten Trennverstärker 106 vorgenommen, da hier schonn eine niederohmige Quelle vorliegt und somit die Stufenteiler, die durch den Stufenschalter 107 angewahlt werden, ohne die Kompensationskondensatoren auskommen. Der Stufenschalter wurde demzufolge zwischen den Meßvorverstärker VI und den Meßverstärker V2 108 geschaltet und erlaubt die Abschwächungen 1; 0,4; 0,2. Parallel zum Stufenschalter 107 wird eine weitere Ebene des Stufenschiebeschalters bewegt, welche die von dem DA-Wandler erzeugten GleichspannungsAusgangsignale an die jeweils der Stufenschalterstellung entsprechenden erforderlichen Spannungspegel (respektive Strompegel) am Eingang des Summationspunktes anpaßt.

**Der Meßverstärker (V2) 108**

Dem Stufenschalter nachgeschaltet ist wiederum ein breitbandiger Meßverstärker 108, der den Gesamtpegel gemäß den Erfordernissen des am Eingang des Parallel-AD-Wandlers gelegenen Pegelfensters verstärkt. Dieses Pegelfenster hat eine Breite von etwa 2,5 V. Er ist nach demselben Prinzip gebaut wie der Meßvorverstärker 106.

## Der Kreuzmultiplexer 120

Dem Kreuzmultiplexer 120 werden an seinen Eingängen die Ausgangssignale zweier Kanalverstärker der oben beschriebenen Art zugeführt. Er gestattet es, vom Hauptmikrocomputer 140 gesteuert die beiden Eingangskanäle im Zeitmultiplex einem oder zwei Analog-Digital-Wandlersystemen parallel oder kreuzweise zuzuführen. Das erlaubt eine Anzahl von unterschiedlichen Systemkonfigurationen. Auf diese Weise können über den Kreuzmultiplexer 120 entweder zwei parallele Kanäle einschließlich der AD-Wandlung gebildet werden oder mit nur einem AD-Wandler im Chopperoder Alternate-Betrieb gefahren werden.

## Der Parallel-Analog-Digital-Wandler (Flash-ADC) 131

Um die Signale mit hoher Bandbreite auswerten zu können, muß ein Parallel-Analog-Digital-Wandler 131 mit möglichst hoher Probenentnahme-Frequenz (Sampling-Rate) Verwendung finden. Diese sogenannten Flash-Wandler werden am Eingang durch parallelgeschaltete, über einen Referenzspannungsteiler quantifizierte Ketten von Hochgeschwindigkeitskomparatoren gebildet. Zum Sample-Zeitpunkt übernimmt jeder de Komparatoren (bei einem 8 bit-Wandler 256 Komparatoren) die Signalerkennung deren Referenzspannungswert gerade über- oder unterschritten wird. Den Komparatoren nachgeschaltete Kodierschaltungen stellen den erkannten digitalen Wert z.B. in einer 8 bit breiten binären Kodifikation im Takt der Sampling-Frequenz am Ausgang des Analog-Digital-Wandlers zur Verfügung.

## Der Conversionsprozessor 130

Da die analogen Signale eine unterschiedliche Bandbreite aufweisen können, und ferner z.B. zur Darstellung der analogen Signale im digitalen Bereich verschiedene Zeitablenkungen oder verschiedene Zeitauflösungen verlangen, empfiehlt es sich, die analogen Signale nicht stets mit der höchstmöglichen Sampling-Rate (Probeentnahmefolgefrequenz) abzufragen. Demzufolge muß die Pulsfolgefrequenz der Abfrageimpulse entsprechend der jeweils vorliegenden Selektionsvorschrift gestaltet werden. Diese Aufgabe übernimmt neben anderen der Conversionsprozessor 130. Ein On-Board-Oszillator entnimmt einem Quarz das Zeitnormal, hier z.B. in Form einer 40 MHz Schwingung. Aus dieser 40 MHz Schwingung kan der 20 MHz breite Abtastimpuls von 25 ns Pulslänge abgeleitet werden und stellt somit die Zeitdauer der Probenentnahme dar. Mit Hilfe von über das Statusmemory setzbaren Sählern wird dann je nach Betriebsart die Sampling-Rate durch die Sampling-Select-Rate untersetzt und die solchermaßen intermittierend entnommenen Proben des 8 bit breiten Signales dem nachfolgenden Schieberegister 1322 zugeführt. Außerdem befindet sich in dem Conversionsprozessor 130 noch ein digitaler Amplitudenkomparator, der es gestattet, die ankommenden Digitalsignale nach Amplitudenkriterien auszuwählen. Systemtheoretisch ist interessant, daß der Conversionsprozessor 130 es gestattet, gemäß den Vorgaben in seinem Statusmemory digitale Signale im Verein mit einem durch ihn angesteuerten Flash-Wandler nach Amplititude und Zeitpunkt zu selektieren. Damit wird eine zunächst im analogen Bereich vorliegende elektrische Nachricht im Amplituden- und Zeitbereich gequantelt. Somit gestattet das System, eine Nachricht vorwählbar punktweise zu zerlegen — ein ganz entscheidender systemtheoretischer Aspekt.

Ferner beinhaltet der Conversionsprozessor 130 noch eine Anzahl anderer Funktionseinheiten, wie die Generierung der Schiebeimpulse und der Shiftcontrollsignale für ein nachgeschaltetes Hochgeschwindigkeits-Schieberegister 132, die Generierung der unterschiedlichen Multiplexsignale, sowie einen setzbaren Pulsgenerator. Ferner ist der Conversionsprozessor 130 so gestaltet, daß er nicht nur einen Flash-Wandler und ein Shiftregister treiben, sondern noch ein zweites System solcher Bausteine (siehe Schaltbild) 160 unabhängig vom ersten treiben kann.

Er stellt einen Hochgeschwindigkeitsspezialprozessor zur Steuerung einer in den Betriebsmodi variablen High-Speed-Analog-Digital-Wandlung einschließlich vorgeschalteter Multiplexung mit nachgeschaltetem Hochgeschwindigkeitsspeicher dar.

## Hochgeschwindigkeitsschieberegister (High-Speed-Shift-Register) 132

Ein wesentlicher Systembaustein ist das Shiftregister für die Hochgeschwindigkeits-Signale. Bei der Hochgeschwindigkeitswandlung analoger Signale treffen die digitalen Signale mit der Probeentnahmefrequenz ein, die mehr als 100 MHz betragen kann, ein. Sie können mit dieser Geschwindigkeit nicht mehr von den schnellsten Mikrocomputern, z.B. Bitslicern, selbst verarbeitet beziehungsweise bearbeitet werden. Demzufolge ist die Einfügung einer Zeitschnittstelle in Form eines Schieberegisters günstig. Normalerweise würde man hier heute Multiplex-Random-Access-Memories verwenden; diese verlangen jedoch die Adressierung über transparente Zähler; ein zusätzlicher Aufwand an Zeit und Bauteilen. Ein Hochgeschwindigkeitsschieberegister 132 bietet hier eine optimale Systemlösung, da das Schieberegister schnell eingelesen und entsprechend den zeitlichen Möglichkeiten des verarbeitenden Prozessors langsamer ausgelesen werden kann. Wird dieses Shift-Register in High-Speed-CMOS Technologie aufgebaut, bietet es außerdem bei der durch die Systemnotwendigkeit erforderlichen intermittierenden Betriebsart den Vorteil, trotz der hohen Geschwindigkeit während der Wartezeiten kaum Strom zu verbrauchen. Das heißt, bei der Verwendung von CMOS-High-Speed-Shiftregistern ist der Stromverbrauch ungleich niedriger als bei ECL-Schaltkreisen — trotz der hohen Einlesefrequenz. Wird das Schieberegister am Ausgang mit Tristate-Ausgängen versehen, so kann es direkt am Systembus anglosen werden. Flash-ADC, Conversionsprozessor 130 und High-Speed-Shift-Register 132 bilden eine systemmäßige Einheit und stellen insbesondere dann, wenn sie auf einem einzigen Chip in 1μ-CMOS Technologie untergebracht werden, eine neue Art von Mikrocomputer dar, der geeignet ist, als hochuniverseller Systembaustein unsere analoge Umwelt mit der Welt der digitalen Datenverarbeitung zu verbinden.

Der Hauptmikrocomputer 140, seine Speicher und die peripheren Einheiten

Am Geräte-Bus angeschlossen ist zunächst der Hauptmikrocomputer 140 — hier beispielsweise ein 8 bit Multi I/O Mikrocomputer mit On-Board RAM, ROM und Oszillator sowie Timereingang mit serieller Schnittstelle und Sonderbefehlen und Befehlsbearbeitungszyklen, die in der Mehrzahl bei 1 μs liegen.

Er dient als Zentralcomputer, um alle Befehle, die von der Tastatur 133 kommen, seinem internen oder auch externen Programmspeicher 142 entsprechend zu bearbeiten, um die von dem Hochgeschwindigkeitsregister 132 angebotenen Signale auszulesen und diese entsprechend der verschiedensten Vorschriften auszuwerten, umzurechnen, im Datenspeicher 141 abzulegen, mit anderen Signalen zu vergleichen, Analysen vorzunehmen und sie schließlich darstellungs- und schnittstellengerecht einem Bildschirm oder einem Graphikprozessor 145, einem Drucker 143 oder der Funktionsgeneratorausgangsschnittstelle 170 oder anderen Schnittstellenprozessoren 144 über den BUS übergeben.

Die Software hierzu kann in einer großen Vielfalt unterschiedlichen Auswertungen und Analysen der ursprünglich analogen Signale vornehmen und diese den verschiedensten peripheren Einheiten mit unterschiedlichen Darstellungen anbieten.

Der Matrix-LCD-Graphikprozessor 145, das LCD 146 und die Bildspeicher 147

Einen Schnittstellenprozessor besondere Art stellt der Graphikprozessor für das im Multiplexverfahren betriebene Matrix-Liquid-Cristal-Display dar. Um den Hauptmikrocomputer nicht allzusehr mit der aufwendigen Verwaltung eines Matrix-LCDs zu belasten, mußte ein Spezialmikroprozessor entwickelt werden. Er gestattet es, im bidirektionalen Busbetrieb mit einem, internen gemultiplexten Bus dem Hauptmikrocomputer jeweils eines der Bild-RAMs zum Einlesen entsprechend den zeitlichen Möglichkeiten des Hauptmikroprozessors anzubieten, während der Spezialprozessor sich jeweils zur Datenbearbeitung der Bildpunkte des Matrix-LCDs des anderen Bild-RAMs bedient. Auf diese Weise konnte erreicht werden, daß der Bildwechsel in einer für den Betrachter nicht wahrnehmbaren Zeitspanne vollzogen werden kann. Ferner liefert der Spezial-Prozessor alle zum Ansteuern der LCDs notwendigen Signale: die seriellen Bilddatensignale, den Punktschiebetakt, den Zeilenendetakt, den Bildanfangstakt und den Bildspannungsvorzeichenwechseltakt. Außerdem können alle Betriebsmodi der Bildpunktkonjunktionen, wie EXOR, AND, OR und Inversion zwischen den beiden Bildspeicherinhalten vorgenommen werden, schließlich können Blinkfunktionen per Software oder Hardware erzeugt werden. Der Spezialprozessor besitzt ein Statusmemory, um Betriebsarten vorprogrammieren zu könen, wie unterschiedliche Multiplexraten für Matrix LCDs unterschiedlicher Bildpunktkomplexität und Bildsteuerungsorganisation.

Die Tastatur 133 und der Tastaturprozessor 134

Die Tastatur 133 dient der Engabe unterschiedlicher Befehlsfolgen zur Steuerung des Gesamtgerätes und ist hier vorzugsweise als Folientastatur ausgebildet.

Sie steuert über eine Matrix die Eingänge des Tastaturprozessors 134, der hier als Multi-I/O-4-bit-Mikrocomputer ausgebildet ist. Er nimmt über zusätzliche Eingänge auch die jeweilige Statusmeldung der verschiedenen Schalterstellungen der BAS und des MBS entgegen, um Tastaturbefehlsfolge und Schalterpositionsmeldungen über seinen Bus nach entsprechendem Interrupt im Handshake-Betrieb weiterzugeben. Außerdem generiert er über seine Timerausgänge die Signale zum Betrieb eines Buzzers, der der akustischen Rückkopplung zwischen Tastatur und Rechner einerseits und dem bedienenden Menschen andererseits dient.

Der Funktionsgenerator 170

Ein wichtiges Funktionselement eines Signalcomputers bildet der mit einem weiteren sparaten Ausgang verbundene Funktionsgenerator 170. Er ermöglicht es, verschiedene Signale gemäß Programm zu erstellen oder zuvor aufgenommene Signale, die sich im Speicher befinden, über einen Multiplexer 148 in ein Hochgeschwindigkeitsschieberegister 149 einzulesen, um es dann über einen Hochgeschwindigkeits-Digital-Wandler 150 und entsprechende Trennstufen nach außen als analoges Signal abgeben zu können.

Das bietet zusätzliche, vielseitige Möglichkeiten. Abgesehen von der Tatsache, daß ein Funktionsgenerator für beliebig durch Vorprogrammierung einstellbare Signalformen geschaffen ist, zum Beispiel solche, die aus einer mathematischen Gleichung abgeleitet sind oder solche, die bereits vorher aufgenommen worden sind bzw. gerade aufgenommen werden, ist das System als Vierpolanalysator nutzbar, der sich selbst von Ausgang zu Eingang zu kalibrieren gestattet und im Wobbelbetrieb mit der Fähigkeit ausgestattet werden kann, selektiv zu filtern und eigenständig Autokorrelationsanalyseprogramme ergebnisabhängig durchzuführen.

Der Triggerkomparator 180

Während das System durch den Aufbau einen rein digital arbeitenden Trigger, programmierbar nach Amplitude und Zeit in beiden Signalkanälen aufweist, der durch den wichtigen Umstand gegeben ist, daß im analogen Bereich keine Speicher, z.B. Charge-coupled-devices verwendet werden, sondern dadurch, daß im Conversions-Prozessor, also im digitalen Bereich, ein Amplitudenkomparator für das 8-bit Signal eingebaut wurde, ist ein annähernd jitterfreies digitales Triggern und ein echter vollautomatischer Trigger möglich. Zusätzlich besitzt das Gerät noch einen externen Triggereingang, dessen Triggerschwelle an einem analogen Komparator entweder fest eingestellt (zum Beispiel auf TTL-Level) werden kann oder über einen DAC programmabhängig eingestellt werden könnte.

Durch den Austausch von Programmteilen und/oder Anschlußelementen läßt sich das erfindungsgemäße Gerät somit in seiner Funktion vollständig verändern und unterschiedlichen Meßaufgaben anpassen. Diese Eigenschaft verdankt es insbesondere der Tatsache, daß der elektrische Signalverarbeitungsteil so ausgelegt ist, daß er sowohl Signale aufnehmen und in dieser zeitlichen Folge graphisch darstellen als auch beliebige Signalabläufe synthetisieren kann, welche Probanden zugeführt werden, wobei die Reaktion des auszutestenden Systems unmittelbar verfolgt und auf dem Schirm dargestellt werden kann. Bei der Benutzung als Logikanalysator dient der ereignisgesteuerte Trigger dazu, nach Erkennung eines vorbestimmten Eingangssignals mit dem im Schieberegister festgehaltenen Signal nach einem vorgegebenen Programm zu verfahren, so daß ohne weiteres auch Mittel zur Signalanalyse implementierbar sind.

Beispiele für auf diese Weise erzeugbare Gerätetypen sind: Universalmeßgerät, Oszilloskop, Schnittstellentester, Speicheroszillograph, Transientenrecorder, Logikanalysator, Frequenzanalysator, Meßgenerator, Wobbelgenerator, Voltmeter, Leistungsmesser, Schallpegelmesser, Autokorrelator, Ratiometrische Meßbrücke, wobei durch die Gestaltung des Schnittstellenmoduls und den dort vorhandenen Anschlußelementen bzw. Verbindungen zu Ein- und Ausgangsanschlüssen sowie durch Gestaltung von Programmteilen das Betriebsverhalten des Geräts und damit seine Gattung festlegbar ist.

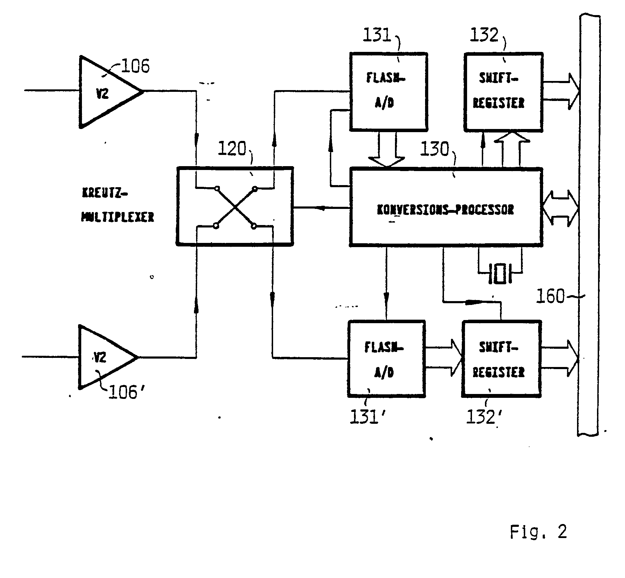

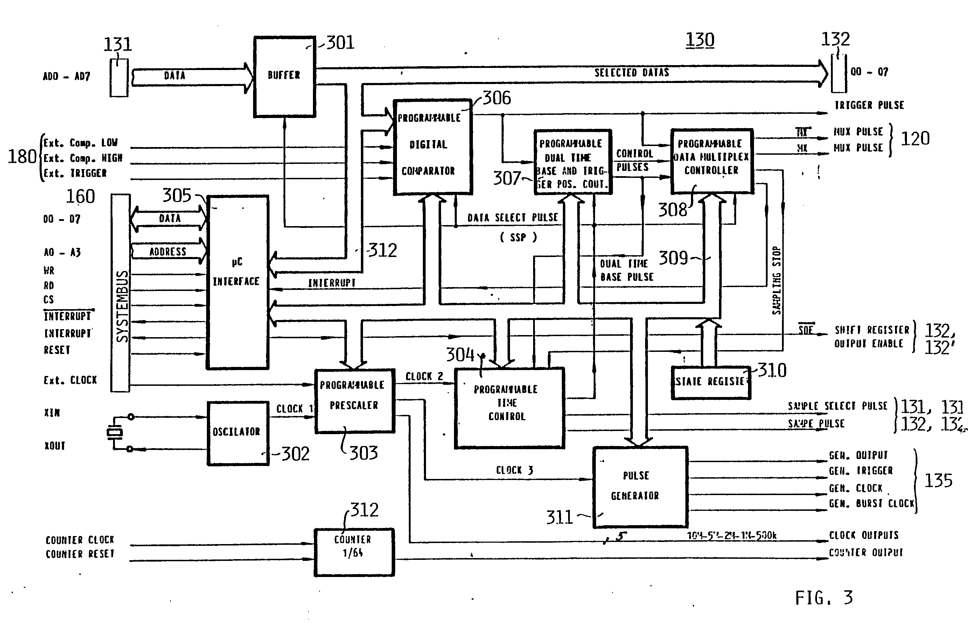

Anschließend werden Details des Conversionsprozessors und der umgebenden Bauelemente noch anhand der weiteren Figuren 2 und 3 beschrieben.

In Figur 2 ist der Kreuz-Multiplexer 120 für den Betrieb des Signalverarbeitungsgerätes als Digitaloszilloskop mit den ihn umgebenen Bausteinen separat wiedergegeben. Die Bezugszeichen entsprechen dabei denjenigen gemäß Figur 1. Es ist ersichtlich, daß der Kreuz-Multiplexer durch interne Umschaltung der Datenverbindungswege sowohl die Ausgangssignale der Eingangsverstärker 106 und 106' den beiden Signalverarbeitungskanälen 131 bzw. 131' separat zuführen kann oder aber die Eingangssignale eines Kanals beiden Flash-Wandlern zuführt, wodurch durch alternierende Taktgabe die Auflösung des Eingangssignals in zeitlicher Hinsicht verdoppelt werden kann. Desweiteren lassen sich auch die Eingangssignale beider Verstärker 106 und 106' einander überlagern.

Figur 3 zeigt die interne Organisation des Konversionsprozessors 130. Die von dem Flash-Wandler 131 eingegebenen Daten gelangen zum Eingang eines Datenpuffers 301, der die Datensätze zwischenspeichert, welche an das Schieberegister 132 weitergegeben werden. Der Konversionsprozessor weist einen selbständigen Oszillator 302 mit einem Quarz auf, dessen Ausgangstakt 1 mittels eines programmierbaren Untersetzers 303 gesteuert untersetzbar ist, wobei auch der Takt des externen Systems berücksichtigt wird. Das Ausgangssignal des programmierbaren Untersetzers bildet den Takt 2, der seinerseits die programmierbare Zeitsteuerung 304 ansteuert, welche die zentrale Steuereinheit für die zeitliche Signalverarbeitung innerhalb des Konversionsprozessors bildet.

Sowohl der programmierbare Untersetzer 303 als auch die programmierbare Zeitsteuerung 304 stehen über ein Interface 305 mit dem System 160 in Verbindung, welches mit dem Hauptmikroprozessor und seiner Peripherie zusammenwirkt. Die Steuerung der programmierbaren Bauelemente des Konversionsprozessors 130 erfolgt also durch Eingabe von Datenworten über den Systembus 160, wobei die programmierbaren Baugruppen über separate Adressen anwählbar sind.

Durch die programmierbare Zeitsteuerung 304 wird durch den Datenauswahlimpuls (SSP) sowohl der Datenpuffer 301 zur Auswahl der einzelnen digitalen Datensätze am Ausgang des Analog-Digital-Wandlers 131 synchronisiert als auch ein programmierbarer digitaler Komparator 306, der die vom Datenpuffer 301 festgehaltenen Daten mit vorgegebenen Daten vergleicht, die ihm vom Systembus 160 über das Interface 305 übertragen wurden. Dabei erfolgt auch die Ansteuerung der Digital-Analog-Wandler 131 und 131' sowie die Taktung der Schieberegister 132 bzw 132' durch von der zentralen Zeitsteuerung abgeleitete Signale (Probenauswahlausgänge der programmierbaren Zeitsteuerung 304) in synchronität mit den Datenauswahlimpulsen.

Der programmierbare digitale Komparator 306 erkennt durch Vergleich der eingehenden digitalen Daten mit dem vorprogrammierten Datenwert den Trigger-Zeitpunkt und gibt daraufhin ein entsprechendes Signal ab, welches auch für externe Verwendung zur Verfügung steht. Für den externen Trigger bekommt der digitale Komparator 306 zusätzlich die Signale vom Trigger-Komparator 160 zugeführt, welche ebenfalls den Triggerzeitpunkt festlegen.

Das Ausgangssignal des digitalen Komparators 306 gelangt weiterhin zu einer programmierbaren zweifachen Zeitbasis 307 mit einem Triggerpositionszähler, welcher einen Zähler enthält, de mit dem Triggerimpuls gestartet wird und jeweils über eingehende Datenauswahlimpulse weitergesetzt wird. Dieser Zählerstand wird mit einem internen über diesen Systembus 160 programmierbaren Register verglichen, das — je nach vorgegebener Lage des Triggerimpulses im darzustellenden Signal — festlegt, wieviele digitale Abfragen des Eingangssignals noch erfolgen müssen, um den erwarteten Signalzug vollständig darzustellen bzw. welche Signalbereiche aus dem Schieberegister zur Signaldarstellung ausgewählt werden (Pre oder Post-Trigger). De Zählerstand bildet also so etwas wie einen Zeiger, dessen Länge die relative Lage des Triggerimpulses zum Beginn der für die Wiedergabe auszuwählenden digitalen Signalfolge bestimmt. Außerdem ist in der Baugruppe 307 noch eine zweifache Zitbasis enthalten, wobei die Umschaltung der Zeitbasis nach Eingang des Triggerimpulses erfolgt. Die Umschaltung der Zeitbasis geischieht über die Verbindung zur programmierbaren Zeitsteuerung 304 über die BUS-Struktur.

Die programmierbare Zeitbasis und das Ausgangssignal SSP des programmierbaren Zeitgebers steuert weiterhin einen programmierbaren Daten-Multiplex-Controller 308, der seinerseits durch Multipleximpulse den Kreuz-Multiplexer 120 in Abhängigkeit von einem über den Systembus 160 und das Interface 305 in ein Register geladenes Wort in seiner Signalverarbeitungsrichtung steuert. Die interne Übertragung der Datenworte im Konversionsprozessor 130 erfolgt dabei über einen internen Bus 309. Den Betriebszustand der Konversionsprozessors kennzeichnenden Daten können dabei zusätzlich aus einem Zustandsregister 310 ausgelesen werden. Über das Interface 305 wird auch ein internes Signal abgeleitet, welches das Schieberegister 132 kontrolliert. Die programmierbare Zeitsteuerung gibt weiterhin Impulse zur Ansteuerung der Flash-Wandler 131 und 131' ab.

Zusätzlich im Konversionsprozessor 130 enthalten ist ein programmierbarer Impulsgenerator 311, der sowohl einige systeminterne Impulse als auch über eine Trennstufe 135 den Impulsgeneratorausgang 136 gemäß Figur 1 ansteuert. Für eine externe Funktion ist zusätzlich innerhalb des Konversionsprozessor ICs ein Zähler 312 implementiert.

Es ist ersichtlich, daß der Konversionsprozessor die gesamte Zeitsteuerung für die Signalaufnahme in vorteilhafter Weise zusammengefaßt enthält, da diese Zeitsteuerung für eine zeitlich hoch auflösende Signalverarbeitung mit großer Geschwindigkeit ablaufen muß. Die Zusammenfassung der betreffenden Funktionen in einer eigenen Baugruppe ermöglicht erst das Konzept des erfindungsgemäßen Gerätes, wobei zu berücksichtigen ist, daß die räumliche Zusammenfassung auch erhebliche Vorteile hinsichtlich der Signallaufzeiten erbringt und auch damit die gewünschte Hochgeschwindigkeitsverarbeitung möglich macht.

Aus den Figuren 1 und 2 ist ferner ersichtlich, daß der Konversionsprozessor bei dem dargestellten Ausführungsbeispiel lediglich die vom Flash-Wandler 131 eines Kanals stammenden Signale über den Puffer 301 (Figur 3) dem Schieberegister 132 zuleitet und dabei die zeitliche Steuerung ausführt. Der zweite Kanal, der für die Triggerung und Signalsteuerung nicht verantwortlich ist, wird am Konversionsprozessor 130 vorbei verarbeitet, wobei das Schieberegister 132' dem Flash-Wandler 131' direkt nachgeschaltet ist. Auf diese Weise ist die Signalverarbeitung erheblich vereinfacht.

Der digitale Trigger-Komparator ist bezüglich der Signalerkennung dadurch verbessert, daß er (programmierbar) die Möglichkeit aufweist, zwei aufeinander folgende Signalzeitpunkte miteinander zu vergleichen, wobei durch Differenzbildung einerseits die Steigung ermittelt und mit einem vorgegebenen Wert verglichen werden kann und außerdem eine Triggerung auch dann möglich ist, wenn das sich ändernde Eingangssignal den vorgegebenen Triggerpegel nicht genau erreicht, sondern bei zwei aufeinanderfolgenden Signalwerten überspringt.

Die Funktion der vorstehend beschirebenen Schaltungen soll nachstehend im Hinblick auf die erfinderischen Lehre auch noch unter anderen Aspekten erläutert werden:

Ein wesentliches Elemente bei der digitalen Bearbeitung analoger Signale ist dabei der Analog-Digital-Wandler, weil er die Schnittstelle zwischen dem analogen und dem digitalen Breich darstellt. Analog-Digital-Wandler verschiedener Systeme sind bisher bekannt. Die seit mehreren Jahren auf dem Markt befindlichen Analog-Digital-Parallel-Wandler jedoch erlauben zum ersten Mal einen Schritt in weit höhere Geschwindigkeiten als die bisher verwendeten approximativen Wandler-Systeme und die anderen bekannten Analog-Digital-Wandler-Prinzipien.

Ein Analog-Digital-Wandler nach dem Parallel-Wandler-Prinzip quantifiziert die Analog-Nachricht durch übereinander gestaffelte Analog-Komparatoren, von denen jeweils der anspricht, der dem anliegenden analogen Signal-Amplitudenwert entspricht. Durch nachgeschaltete Diskriminierungsund Kodifizierungs-Schaltungen wird der solchermaßen quantifizierte Amplitudenwert in einen digitalen Wert gewandelt. Aufgrund dieses Prinzips sind heute Geschwindigkeiten der Analog-Digital-Wandler je nach verwendeter Technologie zwischen 1 MHz und über 100 MHz erhältlich.

Würde eine digitalisierte Nachricht mit der maximalen Geschwindigkeit des Hochgeschwindigkeits-Schieberegisters auf den Bus eines Mikrocomputer-Systems geschaltet, dann wäre derzeit kein Mikrocomputer in der Lage, diese Signalfolge-Geschwindigkeiten zu verarbeiten, da Mikrocomputer-Systeme die Analyse der eintreffenden Digital-Signale sequentiell, beispielsweise in Zusammenarbeit mit Speicherelementen, vornehmen. Aus diesem Grund entsteht an dieser Schnittstelle ein Zeitproblem. Während also die Analog-Digital-Wandler in Parallel-Ausführung zum ersten Mal die Auswertung sehr breitbandiger Analog-Signale gestatten, entsteht ein Zeitproblem, das dadurch definiert werden kann, daß die Informationsfluß-Geschwindigkeit aus dem Flash-Wandler-System durch den Mikroprozessor nicht verarbeitet werden kann. Hier so dieses Problem als "Zeitschnittstellen-Problem" bezeichnet werden.

Dieses Zeitschnittstellen-Problem ist nur durch einen zwischengeschalteten Datenpuffer realisierbar. Dieser Datenpuffer müßte in der Art eines Hochgeschwindigkeits-Datenspeiches ausgeführt sein. Da jedoch bei den multifunktionalen Anforderungen eines Signal-Prozessors diese Daternpufferung ebenfalls mit unterschiedlichen Geschwindigkeiten und nach unterschiedlichen Kriterien erfolgen würde, müßte der Hochgeschwindigkeits-Datenspeicher eine genügend hohe Kapazität besitzen, um danach nach den unterschiedlichen Kriterien die gepufferte Nachricht durch den Mikroprozessor auswerten zu können. Das hätte zwei Nachteile zur Fogle. Zunächst müßten relativ große Speicher verwendet werden, insbesondere dann, wenn es sich um relativ langzeitliche Signale bei hoher Sample-Rate handelt; und zum anderen benötigte der Mikroprozessor eine entsprechend lange Zeit, und diese Nachrichten sequentiell analysieren und abarbeiten zu können. Ferner hätte ein solches Vorgehen auch den nachteil, daß hier keine Real-Time-Auswertung geschehen könnte, weil das Zeitschnittstellen-Problem immer noch besteht.

Eine erste Forderung an einen solchen Hochgeschwindigkeits-Analog-Digital-Konverter-Prozessor, den Konversion-Prozessor, zielt auf eine sehr hohen Datendurchsatz. Da Analog-Digital-Parallel-Wandler heute immer schneller analoge Daten in einen digitalen Datenfluß zu verarbeiten vermögen und gleichzeitig diese Hochgeschwindigkeits-Datenverarbeitung sehr hohe Ströme bzw. elektrische Leistung verlangt, wird die Entwicklung zu integrierten CMOS-Schaltkreisen führen.

Das Zeitschnittstellen-Problem verlangt einen intermittierenden Betrieb. Intermittierend wird hier dahingehend verstanden, daß bei höchster Konversions-Geschwindigkeit die Daten nicht kontinuierlich benötigt, sondern in ihrer Anzahl entsprechend der Speichertiefe des zwischenzuschaltenden Hochgeschwindigkeits-Datenpuffers abgefragt werden, um dann den Datenfluß zu unterbrechen. Solch intermittierender Betrieb wird immer dann systembedingt erforderlich und auch nicht umgehbar sein, wenn die Datenverarbeitung am Ende der informationsverarbeitenden Kette, hier z.B. dem datenaufbereitenden Mikroprozessor, gegenüber der Aufnahmegeschwindigkeit der Daten langsamer erfolgen kann. Das Verhältnis zwischen Hochgeschwindigkeits-Datenaufnahme und Verarbeitungs-Geschwindigkeit der eigentlichen Datenverarbeitung gibt direkt das maximal mögliche Tastverhältnis des intermittierend arbeitenden Systems an.

Bei einem Signal-Computer der vorliegenden Art ist z.B. ein solcher intermittierender Betrieb gegeben, wenn die Probenentnahme z.B. mti 20 MHz erfolgt un der Daten-Zwischenpuffer eine Kapazität von z.B. 512 Byte Länge aufweist. Der gesamte Datenpuffer wäre also in einer Zeit von

$$\frac{512}{20\ \text{MHz}} = 25{,}6\ \mu s$$

gefüllt.

Würden die Daten jedoch nur alle 1 000 µs benötigt, würde das Tastverhältnis

$$\frac{25{,}6}{1\ 000} = 0{,}0256$$

betragen.

Diese Überlegung wurde vorangeschickt, um zu verdeutlichen, welche Vorteile die CMOS-Technologie bei einer Hochgeschwindigkeits-Abtastung aufweisen würde, wenn der Entwurf der Hochgeschwindigkeits-CMOS-Schaltkreise so erfolgt, daß nur dann ein dieser Geschwindigkeit proportionaler Leistungsverbrauch vorliegt, wenn die CMOS-Schaltkreise getaktet werden. Bekannterweise hat die CMOS-Technologie gegenüber z.B. der TTL- oder der ECL-Technik keinen Vorteil, wenn es sich um kontinuierlich verlaufende Hochgeschwindigkeits-Vorgänge handelt. Bei intermittierendem Betrieb jedoch wird während der nichtgetakteten Zeitphasen bei CMOS-Schaltkreisen nur der Leckstrom gezogen, die Leistung geht also auf einen bruchteil des Leistungsbedarfs bei voller Taktgeschwindigkeit zurück.

Daraus resultiert die folgende Überlegung: Wenn ein Flash-Wandler mit der höchsten Geschwindigkeit in CMOS-Technik getaktet werden soll, benötigt er die volle Leistung. Wenn jedoch auf der anderen Seite diese Taktung nur für einen gewissen Zeitraum zu erfolgen hat, sinkt sein Stromverbrauch in etwa linear zum Tastverhältnis. Das gleiche gilt für sämtliche Controller- und Speicher-Bauelemente, sofern sie in CMOS-Technik aufgebaut sind.

Aus diesem Grunde ist für den Konversions-Controller ein intermittierender Sampling-Betrieb vorgesehen. Daraus resultiert, daß der Konversions-Prozessor jene Sample-Impulse in der Folge und mit dem Tastverhaltnis dem CMOS-Flash-Wandler zuführt, die für die intermittierende Datenentnahme notwendig sind.

Nachfolgend wird das generelle Prinzip der gesteuerten Probenentnahme an hand eines Ausführungsbeispiels beschrieben:

Gemäß Blockschaltbild, Fig. 1, ist dem Kreuz-multiplexer und dessen analogem Ausang der AD-Flash-Wandler nachgeschaltet. Je nach desen Auflösung werden die kodierten Signale des Flash-Wandlers z.B. mit 8 bit Breite dem Eingang des Konversions-Prozessors 130 zugeführt (Fig. 2). Die durch den Konversions-Prozessor 130 selektierten Daten werden an dessen Ausgang einem Hochgeschwindikeits-Register zugeführt. Dieser prinzipielle Aufbau gestattet also dem analogen Signal, durch den Konversions-Prozessor gesteuert, intermittierend oder auch kontinuierlich durch den Flash-Wandler 131 Proben zu entnehmen, die dem Shift-Register 132 über das interne gesteuerte Buffer-Register 301 des Konversions-Prozessors zugeführt und in letzterem zwischengespeichert werden, bis durch interne Zähler quantifiziert das Shift-Register die solchermaßen selektierten Daten aufgenommen hat. Der Hauptmikrocomputer kann dann über die z.B. 8 bit breiten Ausgänge des Schift-Registers 132 nach Art eines Stack-Registers zwischengespeicherten Datenworte dem zwischenspeichernden Shift-Register mit der ihm angepaßten und von ihm bestimmten Geschwindigkeit entnehmen.

Der Konversions-Prozessor 130 hat jedoch noch eine Anzahl anderer Aufgaben zu erfüllen. Die beschreibung des Konversions-Prozessors erfolgt unter Hintuziehung des Blockschaltbildes, Fig. 3 das seimen inneren Auflan teigt, Wird zunächst von den Grundaufgabenstellungen ausgegangen, die der Konversions-Prozessor zu erfüllen hat, dann sind dieses folgende:

1. Da der Konversions-Prozessor- den Flash-Wandler in seiner Probenentnahme zu steuern hat und diese Probenentnahme den Zeitpunkt und die Dauer der Probe bestimmt und damit die Proben zeitlich quantifiziert, muß der Konversionsprozessor ein Zeitnormal enthalten. Abgesehen von anderen Applikationen wird bei der Applikation für einen Oszillographen bei dieser Überlegung sofort deutlich, daß die Aneinanderreihung von entnommenen Proben nichts anderes darstellt als die Horizontal-Basis eines Oszillographen, oder — anders ausgedrückt — der Konversions-Prozessor muß das Zeitnormal und die wählbare Zeitbasis bilden.

Für seine strukturelle Auslegung bedeutet dies, daß ein Quarz als Zeitnormal vorhanden sein muß und die zeitliche Folge der Probenentnahmefrequenz und Foglesequenz, also die die Zeitbasis bestimmenden Sampling-Impulsfolgen programmierbar sein müssen.

2. Diese solchermaßen vorprogrammierbare Zeitbasis muß Abfrage-Impulse derart steuern, daß entsprechend den Erfordernissen des Flash-Wandlers aus dem Konversions-Prozessor-Takt Impulse generiert werden, die entsprechend der Grundforderung de Zeitbasis und dem Steuerungsprogramm des AD-Flash-Wandlers am Ausgang des Konversions-prozessors erscheinen.

3. Ferner muß der Konversions-Prozessor insbesondere auch aufgrund seiner Funktion, Signale vorprogrammierbar dem Flash-Wandler entnehmen und eine digitale Trigger-Erkennung realisieren zu können, einen digital vorsetzbaren, d.h. wiederum programmierbaren Amplituden-Diskriminator — in diesem Fall einen programmierbaren Digital-Komparator — enthalten. Dieser Digital-Komparator stellt im Falle der Application eines Oszillographen die Trigger-Funktion dar und kann im Falle des allgemeinen Signal-Computers zur Analyse der Amplituden genutzt werden.

4. Als generelle Aufgabenstellung für den Konversions-Prozessor wären noch zusätzliche Funktionen zu fordern wie z.B. die Generierung unterschiedlicher Zeitbasen abhängig vom Amplituden-Diskriminator oder von vorsetzbaren Zeitkriterien, ferner Zählschaltung zur Überwachung der nachgeschalteten Hochgeschwindigkeits-Speicher sowie die Generierung typischer Signale für die Zusammenarbeit mit dem Mikroprozessor wie Interrupt-Signale und andere Steuersignale.

5. Da es sich um einen hochschnellen digitalen Prozessor handelt, wäre es vorteilhaft, auch noch zusätzliche Signale, die z.B. der Mutliplexer-Steuerung dienen, zu implementieren.

Das Blockschaltbild gemäß Fig. 3 zeigt alle diese Funktionen des komplexen Controllers. Die grundsätzliche Zeitbasis wird durch den Quarz (Q) gebildet. Der Quarz wird im Oszillator 302 über einen invertierenden Eingangs-Buffer und einen Ausgangs-Treiber geschaltet und kann z.B. in 2 µ-CMOS-Technik für z.B. 80 MHz ausgelegt werden. Der so generierte Grundtakt der Zeitbasis wird dem programmierbaren Vorteiler 303 zugeführt. An dessen Eingang befindet sich ein Teiler mit nachgeschalteten Teilerstufen, der den Clock 1 z.B. durch folgende Zahlen teilt:

1, 2, 4, 8, 20, 40 und 80.

Diese möglichen Takt-Frequenzen werden über einen durch das Programm schaltbaren infernen Multiplexer und nachfolgende Flip-Flops so geschaltet, daß die zum Steuern der internen Abläufe im Konversions-Prozessor benötigten Takt-Frequenzen z.B. in der Staffelung

20; 10; 5; 2,5; 1 MHz und 500 KHz

zur Verfugügung stehen. Ferner ist dieser programmierbare Vorteiler 303 so konfiguriert, daß — wie im Blockschaltbild angegeben — zusätzlich ein externer Clock zugeführt werden kann, der den Konversions-Prozessor mit einem anderen Grundtakt steuert, wobei gleichzeitig der durch den Quarz-Oszillator 302 erzeugte Clock benutzt wird, um über Clock 3 den Impuls-Generator zu betreiben oder die intern erzeugten Impulse von

10 MHz; 5 MHz; 1 MHz und 500 KHz

über funf hier gemeinsam mit Clock-Outputs gekennzeichnete Ausgänge zur Verfügung stellen zu können.

Ferner wird vom programmierbaren Vorteiler ein Clock 2 zur Verfügung gestellt, der aus dem 12 Bit- und einem 4 Bit-Zähler aufgebaut ist, der seinerseits die interne Zeitsteuerung des Konversions-Prozessors taktet. Diese Zeitsteuerung besteht einmal aus einem 12 Bit multiplexbaren und vorsetzbaren Zähler und zum anderen aus einem 4 Bit multiplexbaren und vorsetzbaren Zähler. Beide Zähler arbeiten über durch das Programm betimmbare und durch die Multiplexer einstellbare Betriebsarten-Steuerungen, so daß an deren Ausgängen die Sample-Select-Pulse (Proben-Selektions-Impulse) zur Selektionssteuerung für das Shift-Register und gleichzeitig die hierzu korrelierten Sample-Pulse (Probentnahme-Impulse) für den Flash-Wandler generiert werden.

Die Sample-Pulse für den Flash-Wandler 131 (fig. 2) können je nach Betriebsvorschrift des Flash-Wandlers in einer Art Burst-Puls-Mode programmierbar gestaltet werden, da es Flash-Wandler gibt, die zur Entnahme eines einzigen Pulses mit 2 bis 3 oder z.B. 5 Impulsen gesteuert werden müssen, um eine Probe vom Eingang des Flash-Wandlers zum Ausgang desselben zu schieben. Im gegensatz dazu benötigt das Shift-Register 132 jedoch jeweils zum Weiterschieben nur einen Takt-Impuls, dessen Korrelation zum Sample-Pulse des Flash-Wandlers auf diese Weise zeitlich korrekt und entsprechend den Betriebsarten des Flash-Wandlers zugeordnet werden kann.

Auf diese Weise ist es möglich, unterschiedliche und von dem Markt noch gar nicht definierte zukünftige Flash-Wandler und Speicher-System durch Programm auswählbar zu steuern; z.B. sind Flash-Wandler in NMOS-Technik meist dynamisch gekoppelt; bei CMOS-Flash-Wandlern jedoch ist eine statische Kopplung zu erwarten.

Ferner werden am Ausgang des programmierbaren Zeitsteuer-Schaltkreises auch der interne Takt für den internen Daten-Buffer 301, die programmierbare doppelte Zeitbasis-Schaltung sowie der Takt für den Trigger-Positionszähler 307 und der Steuertakt für den programmierbaren Mulatiplex-Steuer-Schaltkreis 308 erzeugt (SSP). Der SSP taktet auch den programmierbaren Digital-Komparator. Diese Komplexe programmierbare Zeitsteuerung für die ihrerseits wiederum programmierbaren Funktionseinheiten ermöglicht — wie zur Daten-Analyse bei unterschiedlichen Zeitbasen notwendig — eine hoch variable Probenentnahme und Hochgeschwindigkeits-Speicher-Steuerung.

Der Datenfluß wird nun durch diese Zeitsteuerung wie folgt bearbeitet:

Die vom Flash-Wandler über den Daten-Bus 131 durch die Sample-Pulse gesteuerten Daten werden dem Daten-Buffer (Register) zugeführt. Dieses Register, das seinerseits durch die Daten-Selektions-Impulse (SSP) gesteuert wird, gibt die durch dieses Tor vereinzelten Daten in den Daten-Bus Selected Datas (selektierte Daten) uber den Ausgang 132 an den Hochgeschwindigkeits-Speicher — hier an ein Hochgeschwindigkeits-Schiebe-Register 132 — weiter.

Parallel an dem Selected-Datas-Bus it ferner der programmierbare Digital-Komparator 306 angeschlossen. Dieser hat innerhalb des Signal-Processing durch den Quarz-Oszillator 302 eine fundamentale Bedeutung. Über den internen Programm-Bus kann dieser Komparator nach Amplitudenwert und Amplituden-Änderungs-Vorzeichen vorprogrammiert werden. Er dient im digitalen Datenbereich der Erkennung der Amplitudenabhängigen Datenmuster und des Vorzeichens der Datenmuster-Änderung. Im analogen Signal-Bereich bedeutet dies äquivalent die Erkennung einer Trigger-Schwelle und des differentiellen Vorzeichens der analogen Nachrichten-Änderung.

Zusammen mit der durch die Zeitbasis steuerbaren Analog-Digital-Wandlung realisiert diese Stufe eine echte digitale Trigger-Erkennung nach Trigger-Flanken-Vorzeichen und Trigger-Amplitude.

Da die solchermaßen erkannten und diskriminierten Daten nachfolgend dem Zwischenspeicher zugeführt werden, kann also hier im Gegensatz zu den sonst üblichen, über CCD-Elemente vorgespeicherten Nachrichten die Trigger-Erkennung innerhalb des vom Flash-Wandler gelieferten digitalen Datenflusses erfolgen und vor allem dieser Erkennungs-Zeitpunkt zur Änderung der internen zeitabhängigen Steuerabläufe im Konversions-Prozessor genutzt werden.

Ein solches Verfahren stellt an die Geschwindigkeit der digitalen Schaltkreise extreme, an der Grenze der Technologie liegende Forderungen, wenn man erreichen will, daß zum Zeitpunkt der Erkennung eines Datenmusters schon für die nächste Probenentnahme eine der Analyse entsprechende Reaktion zur Steuerung aller übrigen Schaltkreise einschließlich des Flash-Wandlers refolgen soll.

Die gesamte Trigger-Funktion kann wie folgt beschrieben weden:

Durch denn Hauptrechner wird die Trigger-Amplitude als digitales Datenmuster dem programmierbaren Digital-Komparator vorgegeben, entsprechend der Auflösung in bit, die durch den Flash-Wandler bzw. Digital-Komparator vorgegeben ist.

Ferner wird das Trigger-Flanken-Vorzeichen als Übergang vom niederwertigeren zum höherwertigeren Bit-Muster (positive Trigger-Flanke) oder vom höherwertigeren zum niederwertigeren Bit-Muster (negative Trigger-Flanke) schreitend vorgegeben.

Es ist auch vorgesehen, daß das Trigger-Vorzeichen indifferent sein kann, das heißt, daß nur von der Trigger-Amplitude (Trigger-Wort) her erkannt werden kann.

Weiterhin ist für Applikationen des Digital-Komparators 306 als Logic-Analyser vorgesehen, einzelne Bits maskieren zu können, um zusammen ein mit den anderen diskriminierenden Vorgaben jedes beliebige Kriterium zur Bit-Muster-Erkennung vorschreiben zu können, das heißt schließlich, daß der programmierbare Digital-Komparator beliebiger Bit-Muster erkennen und in ihrer zeitlichen Position analysieren kann.

Die so erkannten zeitlichen Positionen der selektiv programmierbaren und erkannten Bit-Muster-Positionen stehen am Ausgang des Digital-Komparators zur Verfügung. Sie werden dem programmierbaren Trigger-Positions-Zähler 307, der gleichzeitig ein programmierbarer Zähler für die zweite Zeitbasis darstellt, zugeführt.

Ferner wird durch den Hauptrechner und dessen Daten- und Adress-Bus und über das in dem Konversions-Prozessor befindliche Mikro-Computer-Interface 305 dieser programmierbare Trigger-Positions-Zähler 307 auch die Trigger-Position zeitlich in Relation zur Speicherkapazität des Hochgeschwindigkeits-Schiebe-Registers programmierbare festgelegt.

Da nunmehr also der digitale Trigger-Amplitudenpunkt, dessen Flanken-Kriterium und der Zeitpunkt des Triggerpunktes durch den Hauptrechner, vorgeschrieben wurde, kann das Hochgeschwindigkeits-Schiebe-Register mit dem zeitlichen Nachrichtenausschnitt derart gefüllt werden, daß der Trigger-Punkt entsprechend den Vorgaben des Hauptrechners positioniert ist.

Aus der Sicht des Gesamtsystems heißt das, daß die Abbildung des Zeitverlaufes der Nachricht in Abhängigkeit von dem nach Amplitude und Zeitpunkt vorwählbaren Trigger-Punkt im Hochgeschwindigkeits-Schiebe-Register abgelegt wird. Damit ist erreicht, daß der Konversions-Prozessor einen Nachrichten-Ausschnitt (intermittierender Betrieb) eine Nachricht beliebig nach Zeitpunkt under/oder Amplitude abbilden kann.

Verwendet man zum Beispiel diesen Konversions-Prozessor 130 innherhalb eines Oszillators, so heißt dieses in de Terminologie des Oszillators, daß der Trigger nach der Analog-Digital-Wandlung im digitalen. Bereich der Signale frei wählbar ist nach Zeit und Amplitude und damit auch vollautomatisch immer gefunden und positioniert werden kann als sogenannter Pre- oder Post-Trigger.

Gestaltet man den programmierbaren Trigger-Positions-Zähler so, daß er in seiner Zähler-Kapazität genügend groß ist, kann auch von entsprechend großen Hochgeschwindigkeits-Zwischenspeichern der Zeitausschnitt gewählt werden.

Der programmierbare Positions-Zähler 307 kann auch je nach den durch den Hauptprozessor gesetzten Bedingungen zwischen Normal- und Auto-Trigger unterscheiden, wobei er bei Normal-Trigger-Betrieb dem Hauptrechner die vollzogene Aufnahme erst dann meldet, wenn der vorgesetzte Trigger-Punkt gefunden wurde, während er bei Auto-Trigger-Betrieb aufgenommene Bilder auch dann zur Verfügung anbietet, wenn kein Trigger-Punkt gefunden worden ist.

Darüber hinaus wurde der programmierbare Trigger-Positions-Zähler so gestaltet, daß anstatt nach Amplituden-Kriterien nach digitalen Kriterien oder Taktimpulszahl-Vorgaben des Schieberegisters gesteuert werden und daß ferner eine beliebig vorsetzbare Zahl von Probenaufnahmen erfolgen kann, um dann die Aufnahme bis zum Eintreffen neuer Aufnahme-Kriterien zu stoppen.

Das führt zu Triggerarten, die in Oszillographen bisher noch nicht angewendet wurden. Natürlich kan auch eine Betriebsart angewählt werden, wo ohne Amplituden-Kriterien eine Aufnahme bis zur maximalen Kapazität des Hochgeschwindigkeits-Speicher erfolgen kann (Roll-Betrieb).

Dem Glockschaltbild gemäß Fig. 3 ist weiterhin zu entnehmen, daß neben dem selektierten Daten-Bus parallel geschalteten Digital-Komparator diese Daten auch direkt über das Mikro-Computer-Interface dem Daten-Bus des Hauptmikrocomputers zur Verfügung gestellt werden können.

Dieser Informationsweg bedeutet eine Umgehung des Konversions-Prozessors und führt zum Beispiel bei entsprechend langsam gesteuerter Probenaufnahme zum Dauernden Real-Time-Betrieb mit den aus dem Flash-Wandler stammenden Daten.

Hier läßt sich u.a. nur beispielhaft eine Dauerabfrage bei entsprechender Sample-Folge-Frequenz erreichen, wo der Haupt-Micro-Prozessor diese Datenfolge-Geschwindigkeit verarbeiten kann. Dieser Datenverkehr kann sogar bidirektional erfolgen, d.h. auch der Mikro-Prozessor seinerseits könnte Daten über seinen Bus und über das konversionsprozessorinterne Interface in das Schieberegister einlesen.

Diese besondere Betriebsart führt zu einer hoch interessanten Anwendung der Funktionsumkehr des Hochgeschwindigkeits-Schiebe-Registers 132 (Fig. 2). So lassen sich im Hauptrechner generierte Datenfolgen oder aus dessen Speicher stammende Datenfolgen über das Interface langsam in das Hochgeschwindigkeits-Schiebe-Register einlesen, um an dessen Ausgang diese Daten, mit hoher Frequenz getastet, einem Hochgeschwindigkeits-Digital-Analog-Wandler zuzuführen, der seinerseits wiederum ein Hochgeschwindigkeits-Analog-Signal erzeugen könnte. Für die hier vorliegende Applikation eines Oszillators führt diese Umkehrung zu einem ungewöhnlichen Ergebnis.

Mit Hilfe der Steuerung des Konversions-Prozessors 130 wird eine über den Analog-Ditital-Wandler 131 aufgenommene, im Speicher des Hauptrechners abgelegter Nachricht nach einer beliebigen Speicherzeit wiederum als Hochgeschwindigkeits-Analog-Nachricht über den Digital-Analog-Wandler ausgelesen, wobei das Hochgeschwindigkeits-SchiebeRegister jetzt die Daten-Pufferung in umgekehrter Richtung vornimmt.

Die Schaltungseinheit 307, die den programmierbaren Trigger-Positions-Zähler enthalt, ist gleichzeitig so ausgeführt, daß sie auch als programmierbarer Zänler für die zweite Zeitbasis bei der Abtastung fungieren kann. Im Prinzip führt sie dabei dieselben Aufgaben durch. Wahrend in den programmierbaren Zeitsteuer-Schaltkreis einprogrammiert wird, mit welcher Sampling-Rate die für die zweite Zeitbasis vorgesehene Abtastung erfolgen soll, wird in den programmierbaren Zähler für die zweite Zeitbasis — ähnlich wie für die Trigger-Position — auch der Zeitpunkt (d.h. Position im Schieberegister) einprogrammiert, zu dem die zweite Zeitbasis einsetzen oder/und gegebenenfalls gestoppt werden soll. Der Zähler wird dabei synchron von dem zentralen programmierbaren Zeitsteuer-Schaltkreis getaktet und gibt seinerseits das Zählergebnis in Form eines Impulses als Meldung an den zentralen programmierbaren Zeitsteuer-Schaltkreis zurück, und geichfalls geht dieser Impuls an die programmierbare Multiplex-Steuerung 308. Dieses erzeugt seinerseits nach Beendigung des gesamten Abfrage-, Trigger-Positionierungs- und Zähler-Vorgangs für die zweite Zeitbasis einen generellen Stopp-Impuls zum definitiven Abschalten des gesamten Abfrage-Zykluses für einen Shift-Register-Inhalt, um bei dem pipelineförmigen Shiften der sequentiell eingelesenen Datenworte in das Shift-Register jede weitere Information, die durch Pulsflanken oder andere Ablaufvorgänge entstehen könnten, eindeutig definiert als Abfrage-Ende-Zyklus zu kennzeichnen.

Die Multiplex-Steuerung 308 ist ebenfalls programmierbar. Zunächst erzeugt sie z.B. für die Betriebsarten "Alternate" und "Chopped" oder auch den Einkanal-Betrieb das entsprechende Multiplex-Schalt-Signal und dessen invertiertes Signal. Mit diesen Signalen MX und MX kann der Kreuzmultiplexer in allen geschilderten Betriebsarten gesteuert werden.

Desgleichen kan aufgrund des vom programmierbaren Digital-Komparator 306 gelieferten Trigger-Erkennungs-Impulses für die Trigger-Arten, bei denen die Trigger-Quelle eine andere ist als der abzufragende und aufzuzeichnende Kanal, der Multiplexer-Schaltkreis das Multiplexer-Umschalt-Signal erzeugen, das den Multiplexer-Schalter zunächst auf dem Trigger-Quellen-Kanal hält, bis die Trigger-Amplitude erkannt ist, um dann den Schalter auf den abzufragenden Kanal umzulegen.

Ferner verfügt der Schaltkreis über ein Schift-Register-Output-Enable Signal, das vom Mikrocomputer-Interface gesteuert wird und das dazu dienen kann, den Tristate-Ausgang des Schift-Registers zu steuern.

Um den hochintegrierten Hochgeschwindigkeits-Konversions-Prozessor 130 noch weiterhin zu nutzen, sind außer den Steuerkreisen für die Flash-Wandler, die beschrieben wurden, noch zusätzliche Funktionen eingebaut, die anderen Zwecken der umgebenden Elektronikschaltungen dienen können.

Es ist ein Pulse-Generator vorgesehen, der programmierbar nach Frequenz und Folge Burst-Impuls-Folgen erzeugen kann. Abgeleitet von dem Quarz-Oszillator und dem programmierbaren Vorteiler wird über Clock 3 der PulseGenerator, der seinerseits programmierbar ist, eingebaut. Durch Teilung der angelieferten Frequenzen kann er an seinen vier Ausgängen das solchermaßen programmierte Impuls-Paket über Treiberstufen an die Ausgänge des integrierten Schaltkreises liefern:

1. den Burst-Pulse-Ausgang (Generator-Ausgang);

2. den Trigger-Impuls für das Tastverhältnis des Burst Generator;

3. den Generator-Clock als Grundfrequenz der einzelnen Burst-Impulse;

4. den Generator-Burst-Clock als Tastverhältnis von Burst Impuls-Gesamtdauer zu Burst-Impuls-Paket-Gesamt-Tastverhältnis.

Fernber ist im Gerät noch ein Teiler vorgesehen, der von außen über Counter Clock angelegte Signale durch 64 zu teilen gestattet und als Counter Output wiederum nach außen geführt wird. Über den Eingang Counter Reset kann der Zähler asynchron zurückgestellt werden.

Der Schaltkreis verfügt auch über ein Shift-Register-Output-Enable-Signal-Ausgang, der vom Mikrocomputer-Interface gesteuert wird und der dazu dienen kann, den Tristate-Ausgang des Schift-Registers zu steuern.

Der Konversions-Prozessor ist also im wesentlichen gekennzeichnet durch einen vollständig mikroprozessor-kompatiblen Bus-Eingang 160 für Daten, Adressen und Kontrollsignale. Über einen Mikrocomputer-Interface arbeitet er auf einen internen Bus. Über den internen Bus können ein Vorteiler für den On-board-Oszillator ein zentraler Zeitsteuer-Schaltkreis, ein Impuls-Generator, ein Multiplex-Signal-Erzeuger, ein Zähler für die zweite Zeitbasis und ein Zähler für die Trigger-Position sowie ein digitaler Amplituden-Komparator vorprogrammiert werden.

Ferner bedindet sich ein 8 bit breiter Daten-Bus 131 als Eikngang für die vom Flash-Wandler gelieferten Daten mit einem zwischengeschalteten Buffer-Register 304 darin, das es gestattet, die vom Flash-Wandler gelieferten Daten zu selektieren. Diesem Daten-Selektions-Bus ist ein programmierbarer Komparator parallel geschaltet, der die Daten gemäß dem vorprogrammierten Datenmuster nach dem Muster und nach der Änderung der Muster von größeren zu kleineren oder auch von kleineren zu größeren Mustern erkennen kann.

Zusätzlich können die Kriterien auch über einen externen Trigger-Eingang eingegeben werden. Darüber hinaus ist der Digital-Komparator über die externen Zuleitungen Komparator Low und Komparator High in seiner Bit-Breite noch nach oben erweiterbar.

Der Konversions-Prozessor 130 stellt also einen Schaltkreis dar, der es gestattet, einen Flash-Wandler mit unterschiedlichen Abfragefolgen im sog. intermittierenden Betrieb zu steuern, die von dem Flash-Wandler gelieferten Daten zu selektieren und die gelieferten bit-Muster zu erkennen. Er kan diese selektierten Daten einem nachfolgenden Hochgeschwindigkeits-Spicherelement zuführen, um es optimal zu nutzen. Er kann die nachfolgenden Speicher, sofern sie in Form eines Shift-Registers aufgebaut sind, derart direkt steuern. Er stellt die Shift-Frequenz zur Verfügung und kann über intern programmierbare Zähler die Position der Daten im Shift-Register bestimmen. Er besitzt außerdem ein internes Status-Register, das direkt vom Mikrocomputer lesbar ist und über das z.B. Interrupt- oder Trigger-Meldung oder der gesamte interne Zustand abgefragt und auch getestet werden können.

Insoweit dient diese bidirektionale BUS-Verbindung 160 dem Hauptprozessor von außen zum Einlesen von Daten und kann umgekehrt zur Erkennung des Programm-Status und auch zum Testen des Schaltkreises verwendet werden.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch machen.

**Patentansprüche**

1. Signalverarbeitungsgerät mit mindestens einem Eingang für analoge Eingangssignale, einem digitalen Hochgeschwindigkeitsspeicher, einem Analog-Digital-Wandler und einem Prozessor zur Verarbeitung der das Ausgangssignal des Analog-Digital-Wandlers bildenden digitalen Signalfolge, welche den — vorzugsweise in einem Anzeigefeld darzustellenden — Signalverlauf des Eingangssignals repräsentiert, dadurch gekennzeichnet, daß der Hochgeschwindigkeitsspeicher als Schieberegister oder RAM ausgebildet und dem Analog-Digital-Wandler insbesondere unmittelbar oder unter Zwischenschaltung eines Datenpuffers, nachgeschaltet ist, daß die Ansteuerung ds Analog-Digital-Wandlers (131, 131') und des Hochgeschwindigkeits-Schieberegisters (132, 132') oder RAMs zur Umwandlung des aktuellen Analogsignals in ein digitales Signal und zur Abspeicherung dieses digitalen Signals durch ein einen Datenauswahlimpuls bildendes Taktsignal eines getrennt programmierbaren, einen eigenen Zeitgeber (302 bis 304) enthaltenden Steuerbausteins (130) erfolgt, und

daß der Zeitgeber eine programmierbare Zeitsteuerschaltung (304) aufweist, welche auf Taktsignale am Eingang hin mit einer Folgefrequenz, die durch den Inhalt eines internen programmierbaren Registers bestimmt wird, das Taktsignal abgibt.

2. Signalverarbeitungsgerät nach Anspruch 1, dadurch gekennzeichnet, daß der Zeitgeber einen eigenen Oszillator (302) mit Quarz aufweist.

3. Signalverarbeitungsgerät nach einem der vorangehenden Ansprüche, dadurch gekennzeichnet, daß dem Oszillator ein programmierbarer Untersetzer für die Frequenz der Ausgangsimpulse des Zeitgebers nachgeschaltet ist, wobei die Ausgangsimpulse des Untersetzes die Eingangssignale der programmierbaren Zeitsteuerschaltung (304) bilden.

4. Signalverarbeitungsgerät nach einem der vorangehenden Ansprüche, dadurch gekennzeichnet, daß der Steuerbaustein (130) einen internen BUS für Daten-, Adresen- und Steuersignale aufweist, der mit einem Prozessor (140) für das übrige System, insbesodere über ein Interface (305), verbunden ist.

5. Signalverarbeitungsgerät nach Anspruch 4, dadurch gekennzeichnet, daß durch das Interface (305) die äußere BUS-Struktur mit Daten-, Adresen- und Steuerleitungen für eine interne Busstruktur mit Datenleitungen (309) zum Übertragen von Daten von oder zu den innerhalb des Steuerbausteins vorhandenen Baugruppen, um deren Betriebsverhalten über deren Register programmiert zu beeinflusen oder abzufragen, Datenleitungen (312) für das ausgewählte digitalisierte Signal sowie interne Steuer- und Adressleitungen umgewandelt wird.

6. Signalverarbeitungsgerät nach einem der vorangehenden Ansprüche, dadurch gekennzeichnet, daß der Analog-Digital-Wandler (131, 131') für das Eingangssignal durch das Taktsignal der Zeitsteuerschaltung (304) zur zeitlichen jeweils zur Entnahme einer Signalprobe angesteuert wird.

7. Signalverarbeitungsgerät nach Anspruch 6, dadurch gekennzeichnet, daß auch gegebenenfals notwendige Vorimpulse für den, insbesondere als Flash-Wandler ausgebildeten, Analog-Digital-Wandler durch das Taktsignal gebildet werden, welches dann dem Analog-Digital-Wandler allein entsprechend frühzeitig und mit der notwendigen Impulszahl zugeführt wird.

8. Signalverarbeitungsgerät nach einem der vorangehenden Ansprüche, dadurch gekennzeichnet, daß innerhalb des Steuerbausteins weiterhin ein digitaler Komparator (306) für das digitalisierte Engangssignal und ein digital vorgebares Vergleichssignal vorgesehen ist, der durch das Taktsignal zum Ausführen jeweils eines Vergleichvorgangs ansteuerbar ist, wobei der Komparator bei Übereinstimmung ein diesen Zustand anzeigendes Ausgangssignal abgibt.

9. Signalverarbeitungsgerät nach Anspruch 8, dadurch gekennzeichnet, daß der Komparator dem Datenpuffer (301) nachgeschaltet ist.

10. Signalverarbeitungsgerät nach einem der Ansprüche 8 oder 9, dadurch gekennzeichnet, daß das Vergeichssignal für den Komparator durch ein in sein entsprechendes Register überführbares digitales Signal durch Programmierung vorgebbar ist.

11. Signalverarbeitungsgerät nach einem der Ansprüche 8 bis 10, dadurch gekennzeichnet, daß durch das Ausgangssignal des digitalen Komparators ein Triggersignal für die Darstellung eines ausgewählten Signalverlaufs im Anzeigefeld ausgelöst wird und/oder die Zeitbasis der Darstellung durch Beeinflussung der Abgabe der Taktimpulse durch die Zeitsteuereinheit (304) verändert wird.

12. Signalverarbeitungsgerät nach einem der Ansprüche 8 bis 11, dadurch gekennzeichnet, daß der digitale Komparator ein die Übereinstimmung von Eingangssignal und Vergleichsignal anzeigendes Ausgangssignal abgibt, wenn das Signal am Ausgang des Schieberegisters entweder gleich dem vorgegebenen Signal ist oder aber das vorgegebene Signal sich im Bereich zwischen dem der zugeordneten analogen Amplitude entsprechenden Wert des aktuellen digitalen Signal am Ausgang des Schieberegisters und dem Wert des entsprechenden vorangehenden Signal befindet.

13. Signalverarbeitungsgerät nach einem der Ansprüche 8 bis 12, dadurch gekennzeichnet, daß dem Kompaarator ein programmierbarer Triggerpositionszähler nachgeschaltet ist, der durch Programmierung in einen vorbestimmten Zustand setzbar ist, durch das Taktsignal der Zeitsteuerschaltung herauf- bzw. herunterzählbar ist und ein Ausgangssignal abgibt, wenn ein vorgebener Zählerstand erreicht ist, welches die programmierbare Zeitsteuerung (304) deaktiviert.

14. Signalverarbeitungsgerät nach einem der vorangehenden Ansprüche, dadurch gekennzeichnet, daß eine programmierbare Steuereinheit für eine Multiplexschaltung vorgesehen ist, welche gesteuert durch das Taktsignal in programmierbarer Zuordnung abhaßngig vom Dateninhalt eines internen Registers Impulse an eine Kreuzmultiplexschaltung (120) abgibt, welche in Abhängigkeit von diesen Impulsen die Signaleingänge auf unterschiedliche Weise gemeinsam, getrennt oder zeitlich abwechselnd mit mindestens dem Eingang mindestens eines Analog-Digital-Wandlers verbindet.

15. Signalverarbeitungsgerät nach einem der vorangehenden Ansprüche, dadurch gekennzeichnet, daß der Zeitgeber des Steuerbausteins oder eine andere programmierbare Baugruppe jeweils durch ein aus dem übrigen Sysem übertragenes Datenwort programmierbar ist.

16. Signalverarbeitungsgerät nach einem der vorangehenden Ansprüche, dadurch gekennzeichnet, daß bei zwei oder mehrkanaliger Signalverarbeitung lediglich das Signal eines Eingangskanals dem digitalen Komparator, und gegebenenfalls dem Datenpuffer, zugeführt wird, während das Ekingangssignal der anderen Kanäle direkt verarbeitet wird, wobei der jeweilige Analog-Digital-Wandler ebenfalls vom Taktsignal des Steuerbausteins angesteuert wird.

17. Signalverarbeitungsgerät nach einem der vorangehenden Ansprüche, dadurch gekennzeichnet, daß ein zusätzlicher programmierbarer Impuls- und/oder Funktionsgenerator vorgesehen ist.

**Revendications**

1. Appareil de traitement du signal comportant au moins une entrée pour des signaux d'entrée analogiques, une mémoire numérique à accès rapide, un transducteur analogique-numérique et un processeur pour le traitement de la séquence de signaux numériques qui forme le signal de sortie du transducteur analogique-numérique et qui représente l'allure du signal d'entrée-de préférence à représenter sur un écran, caractérisé par le fait que la mémoire à accès rapide est conçue sous forme d'un registre à décalage ou d'une mémoire à accès sélectif RAM et qu'elle est montée en aval du transducteur analogique-numérique, en particulier directement ou avec interposition d'une mémoire tampon des données,

par le fait que le pilotage du transducteur analogique-numérique (131, 131') et du registre à décalage (132, 132'), ou de la mémoire RAM, à accès rapide, pour la conversion du signal analogique réel en un signal numérique et pour la mise en mémoire de ce signal numérique se fait par l'intermédiaire d'un signal de cadencement, formant l'impulsion de sélection des données, d'un module de commande (130) qui contient un émetteur de temps propre (302 à 304), programmable séparément, et

par le fait que l'émetteur de temps présente un circuit programmable de commande de déroulement dans le temps (304) qui, lorqu'il reçoit des signaux d'horloge à l'entrée, émet le signal de cadencement à une fréquence déterminée par le contenu d'un registre interne programmable.

2. Appareil de traitement du signal selon la revendication 1, caractérisé par le fait que l'émetteur de temps présente un oscillateur (302) à quartz propre.

3. Appareil de traitement du signal selon l'une des revendications précédentes, caractérisé par le fait qu'en aval de l'oscillateur est monté réducteur programmable pour la fréquence des impulsions de sortie de l'émetteur de temps, étant précisé que les impulsions de sortie du réducteur forment les signaux d'entrée du circuit programmable de commande de déroulement dans le temps (304).

4. Appareil de traitement du signal selon l'une des revendications précédentes, caractérisé par le fait que le module de commande (130) présente, pour les signaux de données, d'adresses et de commande, un bus interne qui est relié avec un processeur (140) prévu pour le reste du sytème, en particuier par l'intermédiaire d'une interface (305).

5. Appareil de traitement du signal selon la revendication 4, caractérisé par le fait que, par l'intermédiaire de l'interface (305), la structure extérieure du bus, comportant les conducteurs de données, d'adresses et de commande, est convertie en une structure interne de bus, comportant des conducteurs de données (309) pour transférer des données depuis les ensembles existant à l'intérieur du module de commande, ou vers ces ensembles, pour influencer leur comportement de service en les programmant par l'intermédiaire de leur registre ou pour les interroger, et comportant également des conducteurs de données (312) pour le signal numérisé sélectionné ainsi que des conducteurs internes de commande et d'adresses.

6. Appareil de traitement du signal selon l'une des revendications précédentes, caractérisé par le fait que le transducteur analogique-numérique (131, 131') pour le signal d'entrée es piloté par le signal de cadencement du circuit (304) de commande de déroulement dans le temps, pour prélever, respectivement en fonction du temps, un échantillon du signal.

7. Appareil de traitement du signal selon la revendication 6, caractérisé par le fait que les impulsions préalables, éventuellement nécessaires, pour le transducteur analogique-numérique, en particulier conçu comme transducteur à action instantanée, sont formées par le signal de cadencement qui est alors amené au transducteur analogique-numérique seul, précocement, de façon appropriée, et avec le nombre d'impulsions nécessaires.

8. Appareil de traitement du signal selon l'une des revendications précédentes, caractérisé par le fait qu'à l'intérieur du module de commande est en outre prévu, pour le signal d'entrée numérisé et pour un signal numérique de comparaison, qui peut être prescrit, un comparateur numérique qui peut être piloté par le signal de cadencement pour exécuter chaque fois un processus de comparaison, étant précisé qu'en cas de coincidence, le comparateur émet un signal de sortie indiquant cet état.

9. Appareil de traitement du signal selon la revendication 8, caractérisé par le fait que le comparateur est monté en aval de la mémoire tampon des données (301).

10. Appareil de traitement du signal selon l'une des revendications 8 ou 9, caractérisé par le fait que le signal de comparaison pour le comparateur peut être prescrit par un signal numérique que la programmation peut transférer dans son registre approprié.

11. Appareil de traitement du signal selon l'une des revendications 8 à 10, caractérisé par le fait que le signal de sortie du comparateur numérique provoque un signal de déclenchement de la représentation, sur l'écran, de l'allure d'un signal choisi, et/ou modifie la base de temps de la représentation en influençant l'émission des impulsions de cadencement par le circuit de commande de déroulement dans le temps (304).

12. Appareil de traitement du signal selon l'une des revendications 8 à 11, caractérisé par le fait que le comparateur numérique émet un signal de sortie indiquant la coincidence du signal d'entrée du signal de comparaison lorsque soit le signal apparaissant à la sortie du registre décalage est identique au signal prescrit, soit le signal prescrit se trouve dans une zone située entre la valeur, correspondant à l'amplitude analogique correspondante, du signal numérique réel apparaissant à la sortie du registre décalage et la valeur du signal précédent correspondant.

13. Appareil de traitement du signal selon l'une des revendications 8 à 12, caractérisé par le fait qu'en aval du comparateur est monté un compteur de positions de déclenchement, programmable, que la programmation peut placer dans un état prédéterminé, que le signal de cadencement du circuit de commande de déroulement dans le temps peut faire compter, par valeur croissante, ou décompter, par valeur décroissante, et qui émet un signal de sortie lorsqu'il atteint un état de comptage prescrit qui désactive la commande programmable de déroulement dans le temps (304).

14. Appareil de traitement du signal selon l'une des revendications précédentes, caractérisé par le fait que, por un circuit de multiplexage, il est prévu une unité de commande programmable qui, commandée par le signal de cadencement et en correspondance programmable, fonction des données contenues dans un registre interne, envoie des impulsions à un circuit de multiplexage en mode croisé (120) qui, en fonction de ces impulsions, relie les entrées de signaux, de différentes façons, en commun, séparément ou alternativement dans le temps, avec au moins l'entrée d'au moins un transducteur analogique-numérique.

15. Appareil de traitement du signal selon l'une des revendications précédentes, caractérisé par le fait que l'émetteur de temps du module de commande, ou un autre ensemble programmable, est respectivement programmable par un mot de données transmis en provenance du reste du système.

16. Appareil de traitement du signal selon l'une des revendications précédentes, caractérisé par le fait que, dans le cas du traitement du signal sur deux ou plus canaux, c'est uniquement le signal d'un canal d'entrée qui est amené au comparateur numérique et éventuellement à la mémoire tampon des données, tandis que le signal d'entrée des autres canaux est traité directement, le transducteur analogique-numérique correspondant étant également piloté par le signal de cadencement du module de commande.

17. Appareil de traitement du signal selon l'une des revendications précédentes, caractérisé par le fait qu'il est prévu un générateur d'impulsions et/ou de fonctions programmable supplémentaire.

**Claims**

1. A signal processing device having at least one input for analogue input signals, a high-speed digital store, an analogue-digital converter and a processor for processing the digital signal sequence forming the output signal of the analogue-digital converter and representing the signal pattern of the input signal — preferably to be represented in a display field, characterised in that

the high-speed store is constructed in the form of a shift register or RAM and follows the analogue-digital converter, particularly directly or with the interposition of a data buffer,

that the drive of the analogue-digital converter (131, 131') and of the high-speed shift register (132, 132') or RAM for the conversion of the current analogue signal into a digital signal and for the storage of this digital signal is effected by a clock signal of a controller (13) whch can be separately programmed and contains its own timer (302 to 304), which clock signal forms a data selection pulse, and

that the timer comprises a programmable timing circuit (304) which delivers the clock signal, in response to clock signals at the input, at a repetition rate which is determined by the contents of an internal programmable register.

2. A signal processing device according to Claim 1, characterised in that the timer comprises its own oscillator (302) with crystal.

3. A signal processing device according to any one of the preceding Claims, characterised in that the oscillator is followed by a programmable scaler for the frequency of the output pulses of the timer, the output pulses of the scaler forming the input signals of the programmable timing circuit (304).

4. A signal processing device according to any one of the preceding Claims, characterised in that the controller (130) comprises an internal bus for data signals, address signals and control signals, which bus is connected to a processor (140) for the rest of the system, particularly via an interface (305).

5. A signal processing device according to Claim 4, characterised in that the external bus structure with data lines, address lines and control lines for an interal bus structure with data lines (309) for the transmission of data from or to assemblies present inside the controller in order to influence or interrogate their operating behaviour in a programmed manner via the register, is converted by the interface (305) into data lines (312) for the selected digitalized signal and internal control lines and address lines.

6. A signal processing device according to any one of the preceding Claims, characterised in that the analogue-digital converter (131, 131') for the input signal is driven by the clock signal of the timing circuit (304) to take one signal sample at a time.

7. A signal processing device according to Claim 6, characterised in that any pre-triggers which may be necessary for the analogue-digital converter, which is particularly constructed in the form of a flash converter, are also formed by the clock signal which is then fed to the analogue-digital converter alone, appropriately early and with the necessary number of pulses.

8. A signal processing device according to any one of the preceding Claims, characterised in that further provided inside the controller is a digital comparator (306) for the digitalized input signal and a reference signal which can be preset digitally, which comparator can be driven by the clock signal to execute one comparison operation at a time, and, in the event of agreement, the comparator delivers an output signal indicating this state.

9. A signal processing device according to Claim 8, characterised in that the comparator follows the data buffer (301).

10. A signal processing device according to one of Claims 8 or 9, characterised in that the reference signal for the comparator can be preset by a digital signal which can be transferred into its corresponding register, by programming.

11. A signal processing device according to any one of Claims 8 to 10, characterised in that, by means of the output signal of the digital comparator, a trigger signal is released for the representation of a selected signal pattern in the display panel and/or the time base of the representation is altered by influencing the delivery of the clock pulses by the timing unit (304).

12. A signal processing device according to any one of Claims 8 to 11, characterised in that the digital comparator delivers an output signal indicating the agreement of input signal and reference signal if the signal at the output of the shift register is either equal to the preset signal or the preset signal is in the range between the value, corresponding to the associated analogue amplitude, of the current digital signal at the output of the shift register and the value of the corresponding preceding signal.

13. A signal processing device according to any one of Claims 8 to 12, characterised in that the comparator is followed by a programmable trigger position counter which can be set in a predetermined state by programming, can be caused to count upwards and downwards by the clock signal of the timing circuit and delivers an output signal when a preset count is reached, which signal deactivates the programmable timing (304).

14. A signal processing device according to any one of the preceding Claims, characterised in that a programmable control unit is provided for a multiplex circuit which, controlled by the clock signal, delivers pulses in programmable correlation depending on the data content of an internal correlation depending on the data content of an internal register to a cross multiplex circuit which, depending on these pulses, connects the signal inputs in various ways, jointly, separately or alternately in time, to at least the input of at least one analogue-digital converter.

15. A signal processing device according to any one of the preceding Claims, characterised in that the timer of the controller or another programmable unit can be programmed each time by a data word transmitted from the rest of the system.

16. A signal processing device according to any one of the preceding Claims, characterised in that, in the case of dual-channel or multichannel signal processing, only the signal of one input channel is fed to the comparator, and possibly by to the data buffer, while the input signal of the other channels is processed directly, the particular analogue-digital converter likewise being driven by the clock signal of the controller.

17. A signal processing device according to any one of the preceding Claims, characterised in that an additional programmable pulse generator and/or function generator is provided.

Fig. 1

Fig. 2

FIG. 3